# DEMANDE DE BREVET EUROPEEN

(11) **EP 3 604 606 A1**
(43) Date de publication de la demande: **05.02.2020**
(21) Numéro de dépôt: 18187086.6
(22) Date de dépôt: 02.08.2018
(51) Int. Cl.: C23C 14/02, C23C 14/06, C23C 14/16, C23C 14/34, C23C 28/04, C23C 28/00, H01M 4/88, H01M 8/0206, H01M 8/0208, H01M 8/021, H01M 8/0215, H01M 8/0228, H01M 8/1018

(54) **REVETEMENT POUR LA DIMINUTION DE LA RESISTANCE DE CONTACT D'UN SUBSTRAT METALLIQUE PASSIF AVANT APPLICATION D'UNE COUCHE CONDUCTRICE APPORTANT UNE RESISTANCE A LA CORROSION**

(71) Demandeur: Centre de Recherches Métallurgiques ASBL - Centrum voor Research in de Metallurgie VZW, 1000 Bruxelles (BE)
(72) Inventeur: LAFORT, Adeline, 4910 THEUX (BE); SILBERBERG, Eric, 5340 HALTINNE-GESVES (BE)
(74) Mandataire: Pronovem

(57) **Abrégé**

La présente invention se rapporte à un procédé pour réaliser un revêtement sur un substrat métallique passivé, caractérisé par une étape de dépassivation dudit substrat, comprenant le dépôt sur ledit substrat d'au moins une couche mince dont la composition comporte au moins un élément chimique ayant une affinité particulière pour l'oxygène, de sorte que cet élément capte une partie de l'oxygène présent dans la couche d'oxyde se trouvant à la surface du substrat passivé.

## Description

### Objet de l'invention

La présente invention se rapporte à la réalisation d'un revêtement multi-couches sur un substrat métallique nativement passivé, avec une sous-couche sous la couche conductrice externe, adéquat pour une application nécessitant une conductivité de surface optimisée, par exemple dans le domaine des contacteurs électriques.

### Arrière-plan technologique et état de la technique

La passivation d'un métal ou alliage se réfère à un état où la vitesse de corrosion est notablement diminuée par la présence d'un film passif, qui apparaît souvent par oxydation spontanée, l'oxyde formé à la surface étant insoluble et constituant un obstacle pour des processus chimiques ultérieurs. C'est le cas par exemple pour l'aluminium, l'acier, l'acier inoxydable, le titane, etc.

Contrairement à l'acier au carbone, l'acier inoxydable possède un minimum de 10,5% de chrome qui lui confère une résistance à la corrosion. Toutefois, si la couche protectrice est endommagée, un début de corrosion peut apparaître. Les bonnes propriétés vis-à-vis de la corrosion de l'acier inoxydable et du titane par exemple sont attribuées à la passivation de ces métaux en présence d'oxygène, une couche protectrice d'oxyde métallique se formant à leur surface, aux dépens d'une bonne conductivité métallique de surface, et donc de contact, à laquelle fait obstacle ce type de couche isolante.

La résistance de contact est la partie de la résistance totale d'un système électrique qui peut être attribuée aux interfaces de contact des conducteurs et des connexions par opposition à la résistance intrinsèque qui est inhérente au système.

Dans le contexte des cellules électrolytiques (ou piles à combustible) à membranes échangeuses de proton (acronyme anglais : PEMFC), on parle plus spécifiquement de résistance de contact interfaciale (acronyme anglais : ICR) pour caractériser les propriétés électriques et de contact des interconnexions, principalement entre les plaques bipolaires (acronyme anglais : BP) et les couches de diffusion de gaz (acronyme anglais : GDL).

Les plaques bipolaires assurent la fourniture des gaz (oxygène, hydrogène) et la collecte des électrons et de l'eau produite par la réaction. Historiquement les plaques bipolaires ont été réalisées en graphite, qui présente une faible résistance de contact et une haute résistance à la corrosion. Le graphite a été abandonné car il est coûteux à mettre en oeuvre et fragile et a été remplacé par des métaux emboutis, qui sont peu coûteux, légers, aisés à mettre en oeuvre et possèdent de bonnes propriétés mécaniques, électrique et thermiques. Toutefois ces substrats métalliques, comme l'inox par exemple (de préférence au titane plus coûteux), doivent généralement être revêtus par une couche conductrice pour diminuer leur résistance de contact et augmenter leur résistance à la corrosion (le fer libéré, notamment, est un poison pour les couches de diffusion de gaz et les membranes).

Des revêtements innovants sur inox pour plaques bipolaires ont été investigués récemment dans le cadre de projets de recherche, par exemple à base de métaux nobles (or) ou de nitrures de métaux de transition (tels que CrₓN_{y}, TiN, etc.) ainsi que des revêtements multi-couches.

Selon le cahier des charges pris en compte, l'ICR entre la plaque bipolaire (BP) et la couche de diffusion de gaz (GDL) devrait être inférieur à 10 mOhm.cm² à une pression de compaction P = 100 N/cm², avec une bonne résistance à la corrosion et sans délamination après formage, sachant que la formabilité est meilleure en multi-couches, de même que l'adhérence du revêtement.

On connaît déjà des (demandes de) brevet(s) concernant des revêtements multi-couches sur plaques bipolaires métalliques de piles à combustible.

L'objectif est souvent de combiner les avantages de chaque couche pour améliorer les performances en termes d'adhérence au substrat, de résistance à la corrosion, de conductivité et de propriétés mécaniques.

On trouve notamment les empilements multi-couches suivants :
- substrat/Cr/(Cr ou Ti ou Al et/ou Mo)N/C (CN102723499A) ;
- substrat/Cr ou Ti ou Zr ou W ou Ni ou Ta/nitrure, oxyde ou carbure de ces métaux (KR20130115420A) ;
- substrat/Cr/CrN (dureté)/CrCN (corrosion)/C amorphe (conductivité) (CN102931421A) ;
- substrat inox etché/CrN ou TiN/C (US2016138171A1) ;
- substrat inox/ couche de base /couche intermédiaire /couche externe, toutes trois déposées par ion plating, de sorte que la résistance de contact est réduite et la résistance à la corrosion augmentée (CN107146899A) ;
- substrat métallique/Ti/C-Ti-TiC (CN101800318A) ;
- substrat acier/Ce-CrN ou TiN/DLC (le Ce possède un rôle de « radical scavenging » en vue d'éviter empoisonnement de la pile par le Fe) (US20160240865A1).

Ces documents décrivent l'utilisation de sous-couches métalliques mais un effet dépassivant ne semble pas mentionné en tant que tel, ou alors il est obtenu par etching du substrat métallique : il est plutôt question d'augmenter l'adhérence par rapport au substrat. Il ressort ainsi que le carbone et les carbures sont largement utilisés (afin d'augmenter la conductivité et de diminuer la corrosion).

Dans Huabing Zhang et al. (Journal of Power Sources 198 (2012) 176-181*),* un revêtement multi-couches CrN/Cr est déposé par dépôt ionique à l'arc polarisé pulsé, sur de l'inox 316L pour réaliser des plaques bipolaires de piles à combustible PEM. L'épaisseur de la multi-couche est de l'ordre de 0,4µm. L'ICR est fortement diminué par rapport au 316L nu et tombe à 12,8-8,4 mΩ.cm² sous une pression de 0,8-1,4MPa.

Dans Peiyun Yi et al. (International Journal of Hydrogen Energy 38 (2013) 1535-1543*),* un film multi-couches Cr-N-C est obtenu sur inox 316L par dépôt ionique par pulvérisation magnétron asymétrique en champ fermé, en vue de réaliser des plaques bipolaires de piles à combustible PEM. L'adhésion entre le film et le substrat est fortement augmentée et la résistance de contact interfaciale (IRC) entre la plaque revêtue et la couche de diffusion de gaz simulée tombe à 2,64 mΩ.cm² pour une pression de 1,4MPa. L'épaisseur totale du film est 1,523µm.

Dans Shengli Wang et al. (Journal of Energy Chemistry 26(2017) 168-174), un dépôt ionique à l'arc est appliqué sur de l'inox 316L pour former un revêtement multi-couches Ti/(Ti,Cr)N/CrN pour réaliser des plaques bipolaires de piles à combustible PEM. La résistance de contact interfaciale entre le substrat revêtu et du papier carbone est de 4,9 mΩ.cm² sous une pression de 150 N/cm². Des performances de corrosion supérieures sont observées avec une densité de courant de corrosion de 0,12 µA/cm². Le revêtement a une épaisseur uniforme de 190 nm.

A. Hedayati et al., dans « Iranian Journal of Hydrogen & Fuel Cell 2(2016) 137-149 », ont investigué le comportement à la corrosion et l'ICR de substrat d'inox 316L revêtus par une couche de TiN de 1, 2 and 3 µm d'épaisseur. Dans les conditions de simulation cathodique, une augmentation de l'épaisseur de revêtement de 1 à 3µm conduit à une diminution de la densité de courant de 0,76 à 0,43 µA/cm². La valeur de ICR est de 29,5 mΩcm² pour une pression de 136N/cm².

Dans Zhiyuan Wang et al. (Surface and Coatings Technology 258 (2014) 1068-1074), la résistance à la corrosion et la conductivité de surface d'une plaque bipolaire en acier inox sont améliorées en déposant sur un inox 316L un revêtement multi-couche C/Al-Cr-N par pulvérisation magnétron. L'épaisseur totale du revêtement est d'environ 2,3 µm, soit 0,9 µm pour la sous-couche de carbone et 1,4 µm pour la sous-couche Al-Cr-N. La résistance de contact interfaciale (ICR) diminue avec l'augmentation du chrome et arrive à une valeur minimale de 6,17-4,88 mΩcm² pour une force de compaction entre 120 et 150 N/cm², dans le cas de l'échantillon Al₂Cr₄.

### Buts de l'invention

La présente invention vise à fournir un moyen pour diminuer la résistance de contact d'un substrat métallique présentant une couche passive, en vue d'y appliquer une couche conductrice apportant une résistance à la corrosion.

### Principaux éléments caractéristiques de l'invention

Un premier aspect de la présente invention se rapporte à un procédé pour réaliser un revêtement sur un substrat métallique passivé, caractérisé par une étape de dépassivation dudit substrat, comprenant le dépôt sur ledit substrat d'au moins une couche mince dont la composition comporte au moins un élément chimique ayant une affinité particulière pour l'oxygène, de sorte que cet élément capte une partie de l'oxygène présent dans la couche d'oxyde se trouvant à la surface du substrat passivé.

Selon des modes de réalisation préférés de l'invention, le procédé est en outre limité par au moins une des caractéristiques suivantes ou par une combinaison adéquate de plusieurs d'entre elles :
- le substrat passivé est l'acier, l'acier inoxydable, le titane ou l'aluminium ;
- l'élément ayant une affinité particulière pour l'oxygène est le chrome ou le titane ;
- l'élément ayant une affinité particulière pour l'oxygène est présent dans un alliage dont les autres éléments restent à l'état métallique lors du dépôt de la couche mince ;
- lesdits autres éléments métalliques sont le fer ou le nickel ;
- l'alliage métallique est un acier inoxydable, dont la teneur en nickel est comprise entre 0,5% et 21% en poids et la teneur en chrome est comprise entre et 11,5% et 26% en poids ;
- l'acier inoxydable est du type AISI 304, 316L, 316Ti ou 321 ;
- la ou les couches minces sont déposées par pulvérisation cathodique sous vide ;
- l'on dépose sur ladite couche mince une couche présentant une conductivité électrique et une résistance à la corrosion telles que la résistance électrique ou de contact interfaciale (ICR) du substrat revêtu est inférieure à 10 mΩ.cm² ;
- le substrat subit un décapage avant dépôt de la couche mince.

Un deuxième aspect de l'invention se rapporte à un substrat revêtu comprenant :
- un substrat sélectionné dans le groupe constitué de l'acier, l'acier inoxydable, le titane et l'aluminium ;
- une couche mince intermédiaire d'épaisseur inférieure à 30nm, constituée de titane, de nitrure de titane ou d'acier inoxydable ;
- une couche externe conductrice d'épaisseur comprise entre 40nm et 100nm, et constituée de TiN, CrN, Cr₂N, NiCrN, NiCr₂N ou d'au moins deux sous-couches constituées de ces composés.

Un troisième aspect de l'invention se rapporte à l'utilisation du substrat revêtu comme décrit ci-dessus, pour la réalisation de plaques bipolaires de piles à combustible à membranes échangeuses de protons.

Un quatrième aspect de l'invention se rapporte à l'utilisation du substrat revêtu comme décrit ci-dessus, pour la réalisation de contacteurs électriques.

### Brève description des figures

La figure 1 représente une vue MEB (agrandissements : 1500x et 10000x) d'un substrat inox 316L revêtu avec Cr₂N (sans sous-couche), après déformation (19%, 5% d'élongation respectivement dans les deux dimensions du plan de la plaque).

La figure 2 représente une vue MEB (agrandissements : 1500x et 10000x) d'un substrat inox 316L revêtu avec Cr₂N (avec sous-couche 20nm), après déformation (19%, 5% d'élongation dans les deux dimensions respectives du plan de la plaque).

La figure 3 montre, à titre de vérification de l'effet de la sous-couche d'inox, les spectres XPS Fe2p, Cr2p et Ni2p en surface de la sous-couche d'inox déposé sur un substrat d'aluminium.

### Description de formes d'exécution préférées de l'invention

### Méthodes de mesure utilisées

La résistance de contact interfaciale (ICR) PB/GDL simulé a été mesurée par la méthode potentiostatique sous courant en mode DC et DC pulsé.

La résistance à la corrosion a été mesurée en appliquant 0,7V par rapport à une électrode normale d'hydrogène (NHE) pendant 16h avec barbotage d'oxygène (méthode impulsionnelle).

La déformation a été réalisée par la méthode de Marciniak (Z. Marciniak, K. Kuczynski et T. Pokora. "Influence of the plastic properties of a material on the forming limit diagram for sheet metal in tension". Int. Journal of Mechanical Sciences Vol. 15(10), 789-800, 1973).

Des essais ont été réalisés en déposant par pulvérisation magnétron sous vide (PVD pour *Physical Vapor Deposition* ou *Magnetron Sputtering*) sur substrat inox 316L une couche intermédiaire d'inox (10nm FeNiCr) entre le substrat et le revêtement externe, qui est par exemple une couche de 50 nm de CrₓN ou NiCrₓN. Le but de cette couche intermédiaire, dite « sous-couche d'inox » entre le substrat et le revêtement externe était de promouvoir l'adhérence du revêtement vis-à-vis de la déformation de la plaque (emboutissage).

De manière inattendue, les inventeurs ont découvert que les mesures d'ICR sont bien plus faibles en présence de la sous-couche d'inox de 10nm que dans les mesures sans la sous-couche (voir exemple dans le Tableau 1).

On a également constaté que la présence de la sous-couche diminuait bien davantage l'ICR qu'un décapage tel qu'une attaque acide, ou « etching » (non représenté), mais le décapage a tendance à augmenter la résistance à la corrosion. De plus ICR (NiCrN) est comparable à ICR (20nm Au) mais avec une résistance à la corrosion moindre.

Une hypothèse qui peut être retenue est que la sous-couche d'inox de 10nm agit comme agent désoxydant du substrat d'inox, en ce sens que le flash d'inox déstructurerait la couche passive et permettrait ainsi l'obtention d'une résistance de contact interfaciale faible.

Des mesures XPS sur des échantillons incorporant une sous-couche Ti entre le substrat inox et la couche externe ont montré que, même sans etching, aucune couche passive n'est détectée : l'oxygène se lie au Ti et l'ICR est réduit. Ces tests vérifient l'hypothèse de départ comme quoi un élément de la sous-couche métallique comme le chrome ou le titane se combine vraisemblablement à l'oxygène de la couche passive de l'inox et modifie sa structure avec au final comme effet une modification des propriétés électriques.

Afin d'élargir le domaine d'application, on a testé :
- l'effet de la sous-couche sur la tenue à la déformation ;
- l'effet de la sous-couche sur la tenue à la corrosion ;
- si le mécanisme de désoxydation se retrouvait avec d'autres substrats (ex. Ti, acier, Al, etc.).

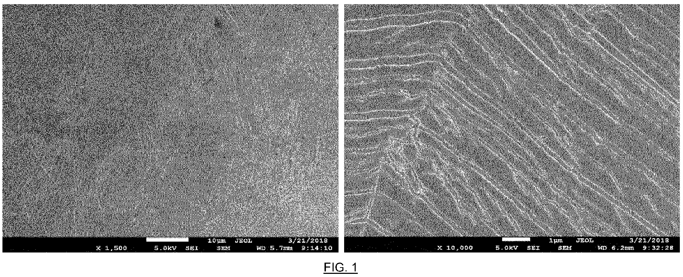

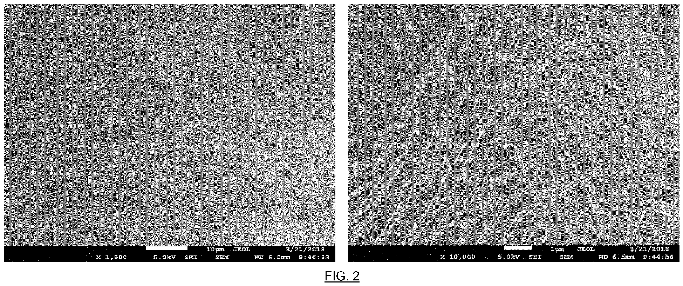

Les figures 1 et 2 montrent des clichés de microscopie électronique à balayage (MEB) respectivement sans et avec sous-couche de 20nm d'inox 316 L (% atomiques : C ≤ 0.3% ; Ni compris entre 10.0 et 13.0% ; Mo compris entre 2.0 et 2.5% et Cr compris entre 16.5 et 18.5%, le reste étant du fer) sur substrat inox également 316L et coating externe Cr₂N, avec etching et pour une déformation de 19% et 5%. Aucune différence notable n'est relevée entre les deux cas entre termes d'adhérence de la couche de Cr₂N.

L'effet de la sous-couche inox sur la tenue à la corrosion après déformation a également été testé (revêtements CrN/FeNiCr/inox 316L) - voir Tableau 2.

Les échantillons réalisés sans etching présentent un courant de corrosion plus élevé que celui de l'inox nu (≅ 0.12µA/cm²), qui est la cible du cahier des charges. La sous-couche d'inox ne semble donc pas influencer le comportement des matériaux en termes de résistance à la corrosion après déformation.

Le Tableau 3 montre les effets sur l'ICR de l'ajout d'une sous-couche entre le substrat et une couche externe de TiN 50nm pour différents substrats (titane, acier, aluminium). L'ajout d'une couche externe de TiN permet dans tous les cas d'atteindre une ICR < 10 mΩ.cm², quel que soit le substrat utilisé (titane, acier ou aluminium).

De l'étude qui précède, on peut tirer les conclusions suivantes :
- l'ajout d'une couche intermédiaire de TiN, de Ti ou d'inox permet de diminuer l'ICR par un phénomène de désoxydation de la couche passive du substrat ;
- la sous-couche permet d'améliorer la résistance à la déformation dans le cas de TiN/Ti(50nm)/inox et est neutre dans le système Cr₂N/inox 20nm/inox ;
- l'ajout de la sous-couche métallique ne modifie par la résistance à la corrosion après déformation dans le système Cr₂N/inox(20nm)/inox ;
- l'effet de désoxydation d'une sous-couche de Ti et du TiN a également été mesuré sur des substrats de titane, d'acier DC01 et d'aluminium.

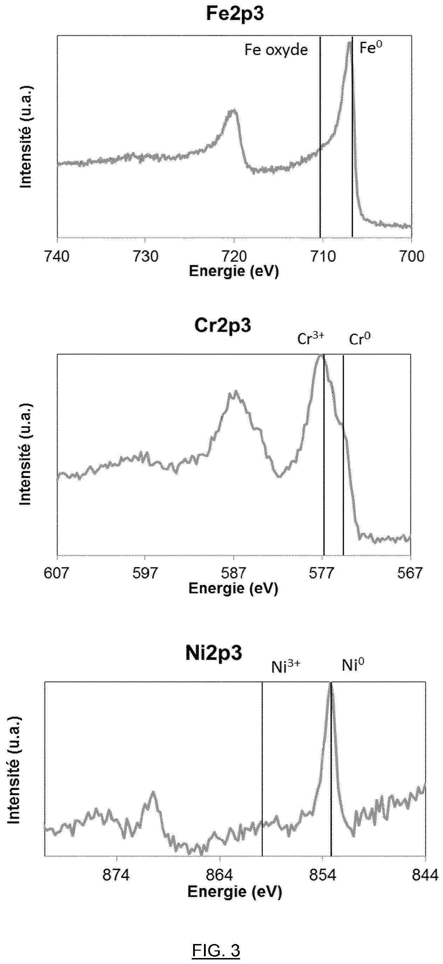

Pour vérifier l'effet de la couche intermédiaire d'inox, on a déposé de l'inox 321 (<0.08% C ; 17-19% Cr ; 9-12% Ni ; <2% Mn ; <1% Si ; 0.3-0.7% Ti ; <0.045% P ; <0.03% S ; reste Fe) sur un substrat d'aluminium (voir figure 3). On remarque que le pic du chrome présente essentiellement une composante oxydée et un léger épaulement relatif à sa composante métallique. Le fer et le nickel présentent, quant à eux, un caractère métallique pur, propice à une bonne conductivité de surface. L'oxygène observé sur le chrome fraîchement déposé provient du substrat et donc de sa dépassivation, attendu que le dépôt d'inox 321 a été réalisé dans une chambre adjacente à la chambre d'analyse XPS, signifiant qu'aucune oxydation de la couche déposée n'a pu se faire entre le dépôt et l'analyse (aucune remise à l'air).

**Tableau 1**

| *N° Ech*. | *Sous-couche inox* | *Coating* | *ICR (mOhm.cm²) à 100N*/*cm²* | *Densité de courant de corrosion (µA*/*cm²)* |
|---|---|---|---|---|
| 1 | oui | NiCr₂N | 2,1 | 0,37 |
| 2 | non | NiCr₂N | 33 | |
| 3 | oui | NiCrN | 0,4 | 0,57 |
| 4 | non | NiCrN | 45 | |

**Tableau 2**

| *N° Ech.* | *Substrat* | *Etching* | *Sous-couche 20nm* | *Coating* | *Déformation* | | *Icorr (µA*/*cm²)* |
|---|---|---|---|---|---|---|---|
| 19 | inox 316L | oui | | Cr2N | 19% | 5% | 0,08 |
| 20 | inox 316L | non | | Cr2N | 19% | 5% | 0,22 |
| 21 | inox 316L | non | inox | Cr2N | 19% | 5% | 0,29 |
| 22 | inox 316L | oui | inox | Cr2N | 19% | 5% | 0,10 |

**Tableau 3**

| *N° Ech.* | *Substrat* | | *Etching Sous-couche 20nm* | *Coating* | *ICR (mΩ.cm²)* |
|---|---|---|---|---|---|
| | Ti | | | | 6,3 |
| 1 | Ti | oui | Ti | Ti 50nm | 3,5 |
| 2 | Ti | oui | | Ti 50nm | 4 |
| 3 | Ti | non | Ti | Ti 50nm | 3,6 |
| 4 | Ti | non | | Ti 50nm | 4,2 |
| 5 | Ti | non | inox | Ti 50nm | 4,7 |
| | DC01 | | | | 264 |
| 6 | DC01 | oui | Ti | Ti 50nm | 3,5 |
| 7 | DC01 | oui | | Ti 50nm | 3,1 |
| 8 | DC01 | non | Ti | Ti 50nm | 3,4 |
| 9 | DC01 | non | | Ti 50nm | 4,5 |
| 10 | DC01 | non | inox | Ti 50nm | 4,6 |
| | Al | | | | 87 |
| 11 | Al | oui | inox | Ti 50nm | 6,4 |
| 12 | Al | oui | | Ti 50nm | 6,5 |
| 13 | Al | non | inox | Ti 50nm | 9,5 |
| 14 | Al | non | | Ti 50nm | 4,6 |
| 15 | Al | non | Ti | Ti 50nm | 10,0 |

## Revendications

1. Procédé pour réaliser un revêtement sur un substrat métallique passivé, **caractérisé par** une étape de dépassivation dudit substrat, comprenant le dépôt sur ledit substrat d'au moins une couche mince dont la composition comporte au moins un élément chimique ayant une affinité particulière pour l'oxygène, de sorte que cet élément capte une partie de l'oxygène présent dans la couche d'oxyde se trouvant à la surface du substrat passivé.

2. Procédé selon la revendication 1, **caractérisé en ce que** le substrat passivé est l'acier, l'acier inoxydable, le titane ou l'aluminium.

3. Procédé selon la revendication 1, **caractérisé en ce que** l'élément ayant une affinité particulière pour l'oxygène est le chrome ou le titane.

4. Procédé selon la revendication 1, **caractérisé en ce que** l'élément ayant une affinité particulière pour l'oxygène est présent dans un alliage dont les autres éléments restent à l'état métallique lors du dépôt de la couche mince.

5. Procédé selon la revendication 4, **caractérisé en ce que** lesdits autres éléments métalliques sont le fer ou le nickel.

6. Procédé selon la revendication 4, **caractérisé en ce que** l'alliage métallique est un acier inoxydable, dont la teneur en nickel est comprise entre 0,5% et 21% en poids et la teneur en chrome est comprise entre et 11,5% et 26% en poids.

7. Procédé selon la revendication 6, **caractérisé en ce que** l'acier inoxydable est du type AISI 304, 316L, 316Ti ou 321.

8. Procédé selon la revendication 1, **caractérisé en ce que** la ou les couches minces sont déposées par pulvérisation cathodique sous vide.

9. Procédé selon la revendication 1, **caractérisé en ce que** l'on dépose sur ladite couche mince une couche présentant une conductivité électrique et une résistance à la corrosion telles que la résistance électrique ou de contact interfaciale (ICR) du substrat revêtu est inférieure à 10 mΩ.cm².

10. Procédé selon la revendication 1, **caractérisé en ce que** le substrat subit un décapage avant dépôt de la couche mince.

11. Substrat revêtu comprenant :
- un substrat sélectionné dans le groupe constitué de l'acier, l'acier inoxydable, le titane et l'aluminium ;
- une couche mince intermédiaire d'épaisseur inférieure à 30nm, constituée de titane, de nitrure de titane ou d'acier inoxydable ;
- une couche externe conductrice d'épaisseur comprise entre 40nm et 100nm, et est constituée de TiN, CrN, Cr₂N, NiCrN, NiCr₂N ou d'au moins deux sous-couches constituées de ces composés.

12. Utilisation du substrat revêtu selon la revendication 11, pour la réalisation de plaques bipolaires de piles à combustible à membranes échangeuses de protons.

13. Utilisation du substrat revêtu selon la revendication 11, pour la réalisation de contacteurs électriques.
